# EUROPEAN PATENT APPLICATION

(11) **EP 4 708 692 A1**
(43) Date of publication of application: **11.03.2026**
(21) Application number: 24199574.5
(22) Date of filing: 10.09.2024
(51) Int. Cl.: H03K 17/082

(54) **METHOD FOR OPERATING A POWER ELECTRONIC SYSTEM AND POWER ELECTRONIC SYSTEM**

(71) Applicant: Hitachi Energy Ltd, 8050 Zürich (CH)
(72) Inventor: GUPTA, Gaurav, 382421 Ahmedabad, Gujarat (IN); PÂQUES, Gontran, 5600 Lenzburg (CH); JONES, Jeremy, 5603 Staufen (CH)
(74) Representative: Michalski Hüttermann & Partner Patentanwälte mbB

(57) **Abstract**

The invention relates to a method for operating a power electronic system (2), the system (2) comprising at least one semiconductor device (4, 20), a driver circuit (6), a detection means (8), and a controller (10),
the driver circuit (6) configured for receiving a logical signal (12) from the controller (10) and for providing a gate signal to the semiconductor device (4, 20) for switching the semiconductor device (4, 20) in a switching cycle from an ON state into an OFF state and from the OFF state into the ON state in normal operation mode,
the detection means (8) configured for detecting a condition with current levels of a collector current of the semiconductor device (4, 20) above a predefined current-threshold limit, and for providing an alert signal (18) associated with the collector current levels of the semiconductor device (4, 20) above the predefined current-threshold limit,
the controller (10) configured for receiving the alert signal (18) from the detection means (8) and configured for providing the logical signal (12) to the driver circuit (6),
the method comprising the steps:
- Receiving the alert signal (18) by the controller (10), and
- Upon receipt of the alert signal (18), continuing switching the semiconductor device (4, 20) in the normal operation mode for at least one switching cycle from the ON state into the OFF state and from the OFF state into the ON state.

Furthermore, the invention relates to a power electronic system (2) configured for performing the above method.

## Description

### Technical Field

The invention relates to a method for operating a power electronic system.

Furthermore, the invention relates to a power electronic system configured for performing the above method.

### Background Art

Semiconductor devices are used as switches controlling the current flow through various electronic systems. Many semiconductor devices make use of a metal-oxide-semiconductor (MOS) structure. Devices that comprise a MOS structure are for example a MOS field-effect transistor (MOSFET), an insulated-gate bipolar transistor (IGBT), or a bi-mode insulated gate transistor (BIGT) being able to operate in both freewheeling diode mode and IGBT transistor mode.

The safe operating area (SOA) is defined as the voltage and current conditions over which a semiconductor device such as the above-mentioned IGBTs or MOSFETs can be expected to operate without self-damage or degradation. In case the semiconductor device is operated outside the SOA a breakdown of the device for example caused by a thermal runaway can occur. As semiconductor devices require some time to turn off, due to effects such as minority carrier storage time and capacitance, the devices may also be damaged while turning off. Thus, a distinction is made between the forward bias safe operating area (FBSOA) and the reverse bias safe operating area (RBSOA), the latter being the SOA during the brief time before turning the device into the OFF state, which is also the short time when the base current bias is reversed.

In order to prevent a breakdown of the device, power electronic systems that comprise a semiconductor device, typically also comprise means for protecting the semiconductor device from overcurrent situations, such as desaturation detection. An important aspect of these protection means is that the semiconductor device is turned off as soon as a fault - such as an overcurrent situation - is detected in a way that prevents damage to the device. Typically, the device is turned off slowly by using a large gate resistor - Rg_{soft} - to discharge the gate or by a step-wise reduction of the current driving the gate to turn off the device within the voltage and current conditions defined by the RBSOA and thus prevent destruction of the device. The protection means however add additionally complexity to the power electronic system and increase costs.

Furthermore, desaturation detection can cause the system to shut down the device in situations where no shut-down is needed due to ambiguities in detection. For example, if the the threshold for the overcurrent detection is not high enough, the desaturation detection might be trigger wrongfully. However, if the threshold is set too high, the device might break down.

Additionally, short term voltage overshoots and/or transient voltage spikes can cause the collector voltage to rise and thus trigger desaturation detection. Typically, to avoid this unnecessary triggering, the power electronic systems comprise filter capacitors to smoothen the course of the voltage over time and thus delay detection of overcurrent situations. The use of filter capacitors however creates a trade-off between the short-circuit withstand time of the device and detection time.

Furthermore, desaturation detection can also be wrongfully triggered by an intended slower switching of the device. The slow switching causes the collector voltage to decrease more slowly and can thus cause the collector voltage to be over the desaturation threshold.

In other words, there is a need to improve the prevention of a breakdown of the device and/or make power electronic systems less complex.

### Summary of invention

It is an object of the invention to improve the performance of power electronic systems, and/or decrease the complexity and/or costs of the power electronic system.

The object of the invention is at least solved in part by the features of the independent claims. Modified embodiments are detailed in the dependent claims.

Thus, the object is at least solved in part by a method for operating a power electronic system, the power electronic system comprising at least one semiconductor device, a driver circuit, a detection means, and a controller, the driver circuit configured for receiving a logical signal from the controller and for providing a gate signal to the semiconductor device for switching the semiconductor device in a switching cycle from an ON state into an OFF state and from the OFF state into the ON state in normal operation mode, the detection means configured for detecting a condition with current levels of a collector current of the semiconductor device above a predefined current-threshold limit, and for providing an alert signal associated with the collector current levels of the semiconductor device above the predefined current-threshold limit, the controller configured for receiving the alert signal from the detection means and configured for providing the logical signal to the driver circuit, the method comprising the steps:
- Receiving the alert signal by the controller, and
- Upon receipt of the alert signal, continuing switching the semiconductor device in the normal operation mode for at least one switching cycle from the ON state into the OFF state and from the OFF state into the ON state.

One aspect of the invention is that the semiconductor device is not switched off immediately after the alert signal is received by the controller. Instead, the semiconductor device is operated in the normal operation mode for at least one switching cycle. Preferably, the semiconductor device is continued to be operated in the normal operation mode for more than one switching cycle, and even more preferably for more than two switching cycles. A switching cycle is defined by two reciprocal switching events of the semiconductor device - i.e. a switching event from the ON state into the OFF state and a switching event from the OFF state into the ON state, or a switching event from the OFF state into the ON state and a switching event from the ON state into the OFF state, such that after completion of the switching cycle, the semiconductor device is in the same state as before the switching cycle. As the semiconductor device is in the ON-state upon receipt of the alert signal, the semiconductor device is continued to be switched for at least one switching cycle from the ON state into the OFF state and from the OFF state into the ON state. Continuing to operate the semiconductor device in the normal operation mode preferably means that no additional measures are taken to slow down the switching of the device as in prior art, but that the process of switching the device is the same as in cases where no alert signal is received.

As the semiconductor device is continued to be operated in the normal operation mode for at least one switching cycle, there is no ambiguity as to whether a turn-off of the device was justified or not. In case the the situation detected by the detection means - i.e. a condition with current levels of the collector current of the semiconductor device above the predefined current-threshold limit - is just temporary, the condition will resolve itself. Additionally, the method allows to dispense of filtering capacitors to delay detection, as there is no risk of an immediate turn-off of the device by temporary voltage overshoots and/or transient voltage spikes. Hence, the method allows to simplify the protection circuity and to make the power electronic systems less complex and thus less expensive.

Preferably, during normal operation mode, the switching of the semiconductor device into the OFF state is performed without using an additional electrical resistance such as Rg_{soft} for slowing down the switching into the OFF state. Instead, preferably the switching is performed with the switching time achievable by the underlying technology of the semiconductor device. For example, switching a Silicon based semiconductor device from the ON state into the OFF state can depending on device architecture and circuit design typically take about 15 µs, while switching a Silicon Carbide based semiconductor device from the ON state into the OFF state is much faster and can be achieved well below 1 µs.

In other words, one aspect of the invention is that even though the alert signal is received by the controller and thus a condition with current levels of the collector current of the semiconductor device above a predefined current-threshold limit was detected, the switching of the device from the ON state in to the OFF state is performed in the same way - in particular regarding switching time and electrical resistance - as when no alert signal is received and thus the collector current of the semiconductor device is at or below the predefined current-threshold limit.

According to a preferred embodiment of the invention the semiconductor device is configured
a) to have a saturation current level Iₛₐₜ of the collector current greater or equal to 1.8 times the nominal current level of the collector current in the ON state, and preferably to have a saturation current level Iₛₐₜ of the collector current greater or equal to 2 times, more preferably 2.2 times and even more preferably 2.4 times the nominal current level of the collector current in the ON state; and/or
b) to have a doping concentration of a channel region and a length of the channel region between a first pn-junction and a second pn-junction along a charge carrier axis such that a gate-emitter threshold voltage Vₜₕ at 25 °C is above 6 V, and such that at 25 °C for
   i) a 6.5 kV semiconductor device a collector-emitter saturation voltage V_{CE(sat)} is in between 2.8 V and 3.2 V, and/or
   ii) a 4.5 kV semiconductor device a collector-emitter saturation voltage V_{CE(sat)} is in between 2.1 V and 2.5 V, and/or
   iii) a 3.3 kV semiconductor device a collector-emitter saturation voltage V_{CE(sat)} is in between 2.0 V and 2.5 V, and/or
   iv) a 1.7 kV semiconductor device a collector-emitter saturation voltage V_{CE(sat)} is in between 1.6 V and 2.0 V, and/or
   v) a 1.2 kV semiconductor device a collector-emitter saturation voltage V_{CE(sat)} is in between 1.3 V and 1.7 V; and/or
c) to have a ratio of a peak doping concentration in cm⁻³ in the channel region to a length of the channel region in cm between a first pn-junction and a second pn-junction along a charge carrier axis of more than 5.8 · 10²¹ cm⁻⁴ for a planar gate architecture or of more than 5 · 10²⁰ cm⁻⁴ for a trench gate architecture.

Regarding feature a) and in other words, the semiconductor device preferably has very low short-circuit current levels Isc, thereby substantially increasing the short-circuit withstand time of the semiconductor device. In short-circuit conditions, the short-circuit current level Isc corresponds to the saturation current level Iₛₐₜ of the collector current.

There are several possibilities how to provide a semiconductor device that has low saturation current level Iₛₐₜ. One possibility is to provide a semiconductor device with an increased threshold voltage Vₜₕ in order to achieve low saturation current level Iₛₐₜ. Another possibility is to operate the semiconductor device at a lower gate emitter voltage V_{GE} A further possibility is to reduce the channel density. These approaches however generally also negatively affect the on-state conduction losses of the semiconductor device.

Above-described features b) and c) are ways to provide a semiconductor device that has low saturation current level Iₛₐₜ without negatively affecting the on-state conduction losses of the semiconductor device.

According to another preferred embodiment, the predefined current-threshold limit is chosen according to the semiconductor device, such that the current at the current-threshold limit does not heat up the semiconductor device to a point, that the semiconductor device gets damaged while continuing to be switched for at least one switching cycle in the normal operation mode. Preferably, the predefined current-threshold limit is also chosen according to the semiconductor device, such that the current at the current-threshold limit can be switched off safely within the normal operation turn-off conditions - in particular without delaying the switching.

Regarding the predefined current-threshold limit, it is further preferred that the predefined current-threshold limit, where the detection means provides the alert signal is equal or greater than 1.8 times the nominal current level in the ON state, preferably equal or greater than 2 times the nominal current level in the ON state, further preferably equal or greater than 2.2 times the nominal current level in the ON state, and further preferably equal or greater than 2.4 times the nominal current level in the ON state. In connection to this it is further preferred that the predefined current-threshold limit, where the detection means provides the alert signal is in between 1.8 times the nominal current level in the ON state and the saturation current level Iₛₐₜ. Preferably, the predefined current-threshold limit is in between 2 times the nominal current level in the ON state and the saturation current level Iₛₐₜ, further preferably in between 2.2 times the nominal current level in the ON state and the saturation current level Iₛₐₜ, and further preferably in between 2.4 times the nominal current level in the ON state and the saturation current level Iₛₐₜ.

For a semiconductor device where neither of above-described features a), b), or c) are realized, the means for protecting the semiconductor device from situations that can potentially lead to the destruction of the device are complex and involve detection and differentiation of different situations.

The short-circuit safe operating area (SCSOA) is defined by all combinations of collector current and collector-emitter voltage that are permitted to occur during nonre-petitive turn-off of the short-circuit current in the semiconductor device without endangering the survival of the semiconductor device. For example, a short circuit failure can occur due to incorrect maintenance, creating a physical short circuit at the restart of the system (e.g. by forgotten tools creating a short circuit), an over current coming from an energy source, an untypical overload situation due to the sudden loss of an energy consumer in the wider system.

The safe operating area (SOA) is defined as the voltage and current conditions over which a semiconductor device can be expected to operate - i.e. repetitive turn-off and turn-on - without self-damage or degradation. Regarding the SOA a distinction is made between the forward bias safe operating area (FBSOA) and the reverse bias safe operating area (RBSOA), the latter being the SOA during the brief time before turning the device into the OFF state, which is also the short time when the base current bias is reversed.

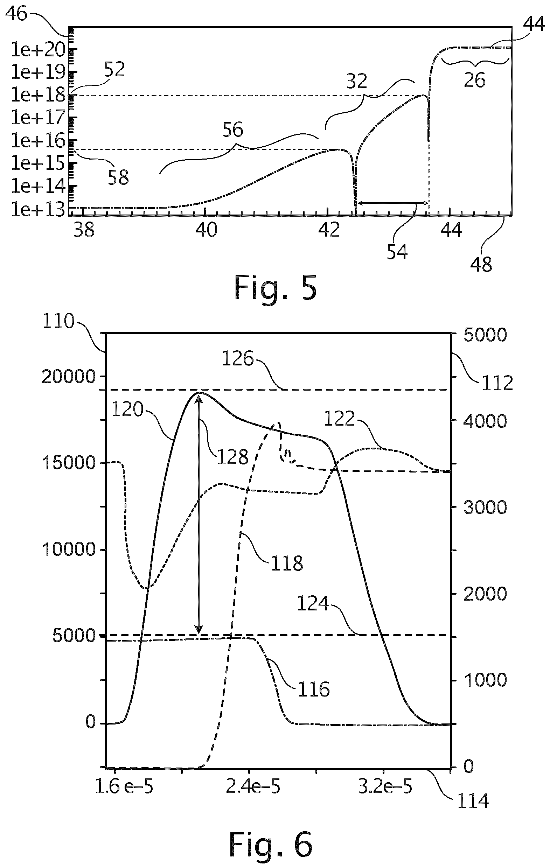

Figure 6 schematically shows a diagram where on the left y-axis 110 of figure 6 the collector current Ic in Ampere is shown on the right y-axis 112 the collector-emitter voltage V_{CE} in Volts, and on the x-axis 114 the time in Second is shown. Curve 116 shows the the collector current during turn-off in normal operation mode, while curve 118 shows the collector-emitter voltage during turn-off in normal operation mode. Furthermore, curve 120 shows the short circuit waveform of the collector current and curve 122 shows the short circuit waveform of the collector-emitter voltage.

As is illustrated in Figure 6, for a semiconductor device where neither of the above-described features a), b), or c) are realized, there is a gap between the RBSOA current level 124 and the SCSOA current level 126 of the semiconductor device. In particular, there can be situations which are not detected by the means for protecting the semiconductor device such as when an over-current exceeds the RBSOA current level 124 however not the SCSOA current level 126. For a semiconductor device where neither of the above-described features a), b), or c) are realized such a situation with current levels in the gap region 128 between the RBSOA and SCSOA can potentially result in failure of the semiconductor device. Figure 6 thus illustrates that by closing the gap region 128 between the RBSOA and SCSOA it possible to reduce the complexity of the means for protecting the semiconductor device e.g. by fully relying on the SCSOA detection. Since no differentiation is needed between uncontrolled RBSOA and SCSOA, the SCSOA detection can potentially also be simplified.

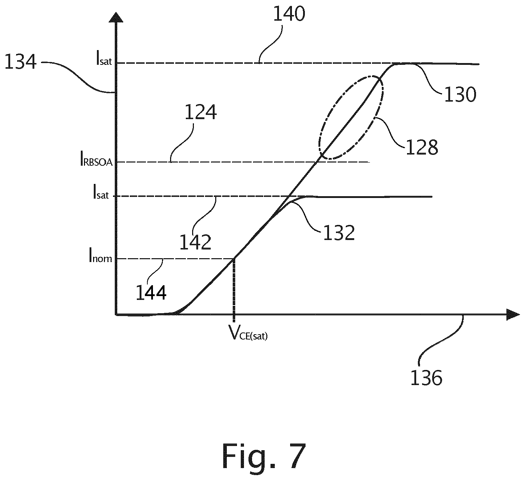

Figure 7 schematically shows the output characteristics 130 of a semiconductor device where neither of the above-described features a), b), or c) are realized, and the output characteristics 132 for a semiconductor device where features a), b) and/or c) are realized. On the y-axis 134 of figure 7 the collector current Ic is shown, the x-axis 136 shows the collector-emitter voltage V_{CE}. For the semiconductor device with the output characteristics 130 where neither of the above-described features a), b), or c) are realized the collector current I_{RBSOA} 124 defined by the RBSOA as well as the saturation current level Iₛₐₜ 140 is indicated. For such a semiconductor device a situation with current levels in the gap region 128 already heats up in the semiconductor device potentially to destruction.

For the semiconductor device with the output characteristics 132 where features a), b) and/or c) are realized the saturation current level Iₛₐₜ 142 is lower. In this example the saturation current level Iₛₐₜ 142 is two times the nominal current level Iₙₒₘ 144 of the collector current in the ON state. Figure 7 illustrates that a semiconductor device with the output characteristics 132 where features a), b) and/or c) are realized closes the gap 128 region between RBSOA and SCSOA.

Regarding features b) and c) of the semiconductor device it is further preferred that the semiconductor device comprises
- a base region of a first conductivity type provided in a substrate,
- a source region being of a second conductivity type different to the first conductivity type provided in the substrate adjacent to the base region for forming the first pn-junction, the source region being configured to be connected to an emitter electrode,
- a drift region being of the second conductivity type provided in the substrate adjacent to the base region for forming the second pn-junction, the drift region being arranged separate from the source region, such that the channel region in between the source region and the drift region is formed in the base region, the drift region being configured to be connected to a collector electrode, and
- an insulation layer arranged next to the channel region for separating the channel region from a gate electrode.

Regarding feature c) it is preferred that the semiconductor device has a channel design where the ratio of the peak doping concentration in cm⁻³ to the length of the channel region in cm is for a planar gate architecture more than 5.8 · 10²¹ cm⁻⁴ and for a trench gate architecture more than 5 · 10²⁰ cm⁻⁴. This channel design has the advantage that it breaks the trade-off relationship between the on-state conduction losses and short circuit withstand capability. Compared to channel designs known in prior art, the length of the channel is reduced while its peak doping concentration is increased. Preferably the channel length is reduced and the peak doping concentration is increased in such a way that the collector-emitter saturation voltage V_{CE}(sat) remains unchanged, while the gate-emitter threshold voltage Vₜₕ is increased. The higher threshold voltage Vₜₕ thus results in lower short-circuit current levels Isc and thus increased short circuit withstand capabilities, while the shorter channel length prevents the collector-emitter saturation voltage V_{CE}(sat) to increase. Thus, the on-state conduction losses do not increase. The gate-emitter threshold voltage Vₜₕ is also called gate threshold voltage and is the minimum gate-to-emitter voltage that is needed to create a conducting path or channel between the emitter/source and drain/collector terminals. Preferably, the gate-emitter threshold voltage Vₜₕ is the gate-emitter voltage at which 10 mA current flows between emitter and collector while the gate electrode is shorted to the collector electrode.

It is further preferred that the doping concentration and the length of the channel region is such that the gate-emitter threshold voltage Vₜₕ at 25 °C is above 6 V, and such that at 25 °C for
i) a 6.5 kV semiconductor device the collector-emitter saturation voltage V_{CE(sat)} is in between 2.8 V and 3.2 V, and/or
ii) a 4.5 kV semiconductor device the collector-emitter saturation voltage V_{CE(sat)} is in between 2.1 V and 2.5 V, and/or
iii) a 3.3 kV semiconductor device the collector-emitter saturation voltage V_{CE(sat)} is in between 2.0 V and 2.5 V, and/or
iv) a 1.7 kV semiconductor device the collector-emitter saturation voltage V_{CE(sat)} is in between 1.6 V and 2.0 V, and/or
v) a 1.2 kV semiconductor device the collector-emitter saturation voltage V_{CE(sat)} is in between 1.3 V and 1.7 V.

In other words, the semiconductor device has improved on-state and short-circuit characteristics which are otherwise limited by the conventional trade-off between short-circuit current levels Isc - i.e. the saturation current level Iₛₐₜ - and gate-emitter threshold voltage Vₜₕ. Thus, it is possible to reduce the saturation current level Iₛₐₜ as required for closing the gap between RBSOA and SCSOA detection without compromising the on-state losses of the semiconductor device.

Regarding the structure of the semiconductor device, the semiconductor device preferably comprises several regions provided in the substrate being adjacent to each other - i.e. the source region being provided adjacent to the base region and the drift region being provided adjacent to the base region. As the base region is of the first conductivity type, preferably p-type, and the source region and the drift region are of the second conductivity type, preferably n-type, two pn-junctions are formed within the substrate.

When a voltage V_{GE} is applied to the gate electrode electric charges are induced between the insulation layer and the interface, which creates an inverted channel region, such that when the applied voltage V_{GE} is above the gate-emitter threshold voltage Vₜₕ, charge carriers, preferably electrons, start flowing from the emitter electrode to the collector electrode via the channel region.

Preferably the semiconductor device can be configured with a planar gate architecture or with a trench gate architecture. In the planar gate architecture, the gate electrode is preferably arranged planarly on the semiconductor device, such that within the channel region the charge carrier axis is arranged perpendicularly to a connection axis that connects the emitter electrode with the collector electrode. In other words, the channel region is arranged horizontally, when the emitter electrode and the collector electrode are arranged vertically on top of each other.

In the trench gate architecture, the gate electrode is preferably carved into the semiconductor device, such that within the channel region the charge carrier axis is arranged parallel to a connection axis that connects the emitter electrode with the collector electrode. In other words, the channel region is arranged vertically, when the emitter electrode and the collector electrode are arranged vertically on top of each other.

According to another preferred embodiment of the invention, the channel length is below 2 µm. Having a channel length below 2 µm provides a semiconductor device having an even more increased short circuit withstand capability without negatively affecting the on-state conduction losses.

According to another preferred embodiment of the invention, the source region is a n-type source region, and/or the base region is a p-type base region. In other words, in this preferred embodiment the semiconductor device is preferably of the n-type channel type, where upon inversion an n-type channel is formed in the channel region, with electrons being the majority charge carriers. As electrons have a higher mobility than holes, faster switching speeds are possible.

According to another preferred embodiment of the invention, the semiconductor device is configured as MOSFET (metal-oxide-semiconductor field-effect transistor), IGBT (insulated-gate bipolar transistor), or BIGT (bi-mode insulated gate transistor). Particularly preferably the semiconductor device is configured as MOSFET or IGBT and further preferably as n-type MOSFET or n-type IGBT.

MOSFETs and IGBTs are different types of transistors having many common features, however the terminology is often different. While in an IGBT the electrode that provides the charge carriers is generally termed "emitter electrode" in a MOSFET this electrode is generally termed "source electrode". On the other hand, the "collector electrode" of the IGBT is in the MOSFET generally termed "drain electrode".

According to a further preferred embodiment of the invention, the semiconductor device comprises a semiconductor material selected from the group consisting of silicon (Si), silicon carbide (SiC), gallium nitride (GaN), gallium(III) oxide (Ga₂O₃), aluminium nitride (AlN), aluminium gallium nitride (AlₓGa₁₋ₓN), gallium arsenide (GaAs), and diamond. Preferably, the semiconductor material is silicon. Particularly preferably, the semiconductor device is a silicon IGBT.

As already mentioned, the method comprises the steps of
- Receiving the alert signal by the controller, and
- Upon receipt of the alert signal, continuing switching the semiconductor device in the normal operation mode for at least one switching cycle from the ON state into the OFF state and from the OFF state into the ON state.

According to another preferred embodiment the step of continuing switching the semiconductor device in the normal operation mode for at least one switching cycle from the ON state into the OFF state and from the OFF state into the ON state is performed for no longer than a predefined number of switching cycles. In other words, it is preferred that after some time the semiconductor device is not switched any more or not switched anymore in the normal operation mode. The method thus provides the possibility to adjust the operation of the semiconductor device to the circumstances after a predefined number of switching cycles after receipt of the alert signal. The predefined number of switching cycles can for example be 1.5, 2, or 2.5 or it may be higher. It is further preferred that the predefined number of switching cycles is configurable. This has the advantage that the method can be adapted to different power electronic systems and/or different circumstances.

In this regard and according to another preferred embodiment the method comprises the step of shutting the power electronic system down after a predefined number of consecutive switching cycles from the ON state into the OFF state and from the OFF state into the ON state during which the alert signal is received. Being in a condition with current levels of the collector current of the semiconductor device above the predefined current-threshold limit over a longer time generally indicates that a fault in the system has occurred that may not be temporary. Thus, it is advantageous to shut the power electronic system down after the predefined number of consecutive switching cycles. It is preferred that the predefined number of consecutive switching cycles is configurable. This has the advantage that the method can be adapted to different power electronic systems. It is further preferred that the predefined number of consecutive switching cycles after which the shut-down of the power electronic system is initiated is one switching cycle, two switching cycles, three switching cycles, four switching cycles, five switching cycles, six switching cycles, or seven switching cycles. In other words, and for example in case the shut-down of the power electronic system is initiated after one switching cycle, upon receipt and during receipt of the alert signal, the semiconductor device is switched in the normal operation mode from the ON state into the OFF state and from the OFF state into the ON state, and then turned in to the OFF state for shutting the system down. For example in case the shut-down of the power electronic system is initiated after two switching cycle, upon receipt and during receipt of the alert signal, the semiconductor device is switched from the ON state into the OFF state, into the ON state, into the OFF state, into the ON state in the normal operation mode, and then turned in to the OFF state for shutting the system down.

According to another preferred embodiment of the invention, the step of shutting the power electronic system down is performed by ceasing to provide the logical signal to the driver circuit by the controller and/or by ceasing to provide the gate signal to the power semiconductor device. This is an efficient way to ensure shutdown of the power electronic system.

In this regard and according to another preferred embodiment of the invention the step of shutting the system down comprises the step of switching the semiconductor device into the OFF state in normal operation mode. In other words, it is preferred that the last switching event - i.e. from the ON state into the OFF state - after the at least one switching cycle from the ON state into the OFF state and from the OFF state into the ON state in normal operation mode upon receipt of the alert signal, is also performed in normal operation mode. In other words, in this preferred embodiment the switching OFF of the semiconductor device is not performed slowly by using a large gate resistor - Rg_{soft} - or by a step-wise reduction of the current driving the gate.

According to an alternative embodiment of the invention, step of shutting the system down comprises the step of switching the semiconductor device into the OFF state in a safe-turnoff mode. In other words, in this alternative it is preferred that the last switching event - i.e. from the ON state into the OFF state - after the at least one switching cycle from the ON state into the OFF state and from the OFF state into the ON state in normal operation mode upon receipt of the alert signal, is not performed in normal operation mode. Instead, the last switching event is preferably performed slowly in the safe-turnoff mode with a large gate resistor - Rg_{soft} -or by a step-wise reduction of the current driving the gate. In other words, it is preferred that the last switching event is performed slower than the previous consecutive switching events.

It is further preferred that the semiconductor device is a silicon (Si) based semiconductor device and that the step of continuing switching the semiconductor device in the normal operation mode for at least one switching cycle from the ON state into the OFF state and from the OFF state into the ON state is performed for at least 15 µs, preferably at least 30 µs, more preferably at least 40 µs, and even more preferably for at least 50 µs.

It is further preferred that the semiconductor device is a silicon (Si) based semiconductor device and the step of continuing switching the semiconductor device in the normal operation mode for at least one switching cycle from the ON state into the OFF state and from the OFF state into the ON state is performed for no longer than 60 µs.

It is further preferred that the semiconductor device is a silicon carbide (SiC) based semiconductor device and that the step of continuing switching the semiconductor device in the normal operation mode for at least one switching cycle from the ON state into the OFF state and from the OFF state into the ON state is performed for at least 1.5 µs, preferably at least 3 µs, more preferably at least 4 µs, and even more preferably for at least 5 µs.

It is further preferred that the semiconductor device is a silicon carbide (SiC) based semiconductor device and the step of continuing switching the semiconductor device in the normal operation mode for at least one switching cycle from the ON state into the OFF state and from the OFF state into the ON state is performed for no longer than 6 µs.

According to another preferred embodiment of the invention, the method comprises the step of monitoring operation to detect the condition with current levels of the collector current of the semiconductor device above the predefined current-threshold limit. Particularly preferably the operation is monitored to detect the condition with current levels of the collector current of the semiconductor device equal or above two times the nominal current level in the ON state, preferably equal or above 2.2 times the nominal current level in the ON state, and further preferably equal or above 2.4 times the nominal current level in the ON state.

It is possible for detecting the condition with current levels of the collector current of the semiconductor device above the predefined current-threshold limit by directly monitoring the collector current. Alternatively, it is also possible to detect the condition with current levels of the collector current of the semiconductor device above the predefined current-threshold limit indirectly e.g. by monitoring the collector-emitter voltage V_{CE} in connection with a desaturation detection. For monitoring operation to detect the condition with current levels of the collector current of the semiconductor device above the predefined current-threshold limit it is for example possible to use Hall-effect sensors, gate voltage monitoring, induced voltage based current detection methods, change of current versus time (di/dt) detection, desaturation detection and/or shunt resistors.

Further preferably change of the collector current versus time is monitored. Alternatively, or additionally the saturation current level, is monitored. These are easy to implement measures to detect conditions with current levels of the collector current of the semiconductor device above the predefined current-threshold limit.

Different ways can be chosen to implement the step that upon receipt of the alert signal, the semiconductor device is continued to be switched in the normal operation mode for at least one switching cycle from the ON state into the OFF state and from the OFF state into the ON state. In this regard and according to a preferred embodiment of the invention, the method comprises the step of increasing a counter upon receipt of the alert signal, and wherein the step of continuing switching the semiconductor device in the normal operation mode for at least one switching cycle from the ON state into the OFF state and from the OFF state into the ON state is continued as long as the counter is below a predefined counter-threshold value. This is a simple possibility to provide flexibility to adjust the predefined number of switching cycles to the operation conditions of the semiconductor device and/or to the circumstances.

Different ways can be chosen to implement the step that upon receipt of the alert signal, the semiconductor device step of shutting the power electronic system down after a predefined number of consecutive switching cycles from the ON state into the OFF state and from the OFF state into the ON state during which the alert signal is received. In this regard and according to a preferred embodiment of the invention, the method comprises the step of increasing a counter upon receipt of the alert signal, and wherein the method comprises the step of shutting the power electronic system down after the counter has reached a predefined counter-threshold value. This is a simple possibility to provide flexibility to adjust the predefined number of the consecutive switching cycles during which the alert signal is received and before a shutdown is initiated.

Further embodiments and advantages of the method for operating the power electronic system are directly and unambiguously derived by the person skilled in the art from the description of the power electronic system and from the description of the specific examples.

The object of the invention is also solved at least in part by a power electronic system comprising at least one semiconductor device, a driver circuit, a detection means, and a controller, the driver circuit configured for receiving a logical signal from the controller and for providing a gate signal to the semiconductor device for switching the semiconductor device from the ON state into an OFF state and from the OFF state into the ON state in normal operation mode, the detection means configured for detecting a condition with current levels of the collector current of the semiconductor device above a predefined current-threshold limit, and for providing an alert signal associated with the collector current levels of the semiconductor device above the predefined threshold limit, the controller configured for receiving the alert signal from the detection means and configured for providing the logical signal to the driver circuit, and wherein the system is configured for performing the above described method.

The power electronic system has the advantage that its complexity is reduced, as no additional effort needs to be put in the detection and control of collector current levels of the semiconductor device above the predefined threshold limit, which typically would also mean that adding additional safety margins are added to the system. Thus, manufacturing and operation costs are reduced.

According to a preferred embodiment of the invention, a power electronic system is provided wherein the detection means is a desaturation detection circuit or a shunt resistor circuit. These are possible ways to detect collector current levels of the semiconductor device above the predefined threshold limit without adding complexity to the power electronic system.

In this regard and according to another preferred embodiment of the invention, the detection circuit is a desaturation detection circuit free of a capacitor. As it is not necessary to distinguish between transient voltage spikes and/or short-term voltage overshoots and more persistent current levels over the predefined threshold limit, no smoothening of the course of the voltage/current over time and thus no delayed detection of overcurrent situations is needed. This keeps the complexity of the desaturation detection circuit low.

According to another preferred embodiment the desaturation circuit is integrated into the driver circuit. This is a further possible implementation that has the advantage of low complexity and low cost. Preferably the driver circuit is configured as isolated gate drive with a desaturation detection.

According to another preferred embodiment of the invention wherein the driver circuit is free of a gate resistor for performing a safe-turnoff. As the method preferably switches the semiconductor device form the ON state into the OFF state in normal operation mode, there is no need for large gate resistor - Rg_{soft} - to slowly turn off the semiconductor device. This further reduces the complexity of the power electronic system.

According to another preferred embodiment of the invention, the power electronic system comprising at least one second semiconductor device, wherein the first semiconductor device is configured such that the saturation current level Iₛₐₜ of the collector current of the first semiconductor device lies below an I_{RBSOA} collector current defined by a reverse-bias safe operating area of the second semiconductor device. Such a power electronic system has the advantage that upon receipt of the alert signal the first semiconductor device can be switched off in normal operation mode - which is faster than in the safe-turnoff mode - and thus protects the second semiconductor device from overcurrent situations.

These and other aspects of the invention will be apparent from and elucidated with reference to the embodiments described hereinafter.

In the drawings:
- Fig. 1: schematically shows a power electronic system according to a preferred embodiment of the invention,
- Fig. 2: schematically shows a flow chart diagram of a method for operating a power electronic system according to a further preferred embodiment of the invention,
- Fig. 3: schematically shows a flow chart diagram of a method for operating a power electronic system according to an alternative further preferred embodiment of the invention,
- Fig. 4: schematically shows a semiconductor device with a planar gate architecture that can be used in the power electronic system of figure 1 or that can be operated according to the methods shown in figures 2 and 3,
- Fig. 5: schematically shows a doping profile of the semiconductor device of figure 4,
- Fig. 6: schematically shows switching waveforms during normal operation and short circuit waveforms, and
- Fig. 7: schematically shows output characteristics of two semiconductor devices.

### Description of embodiments

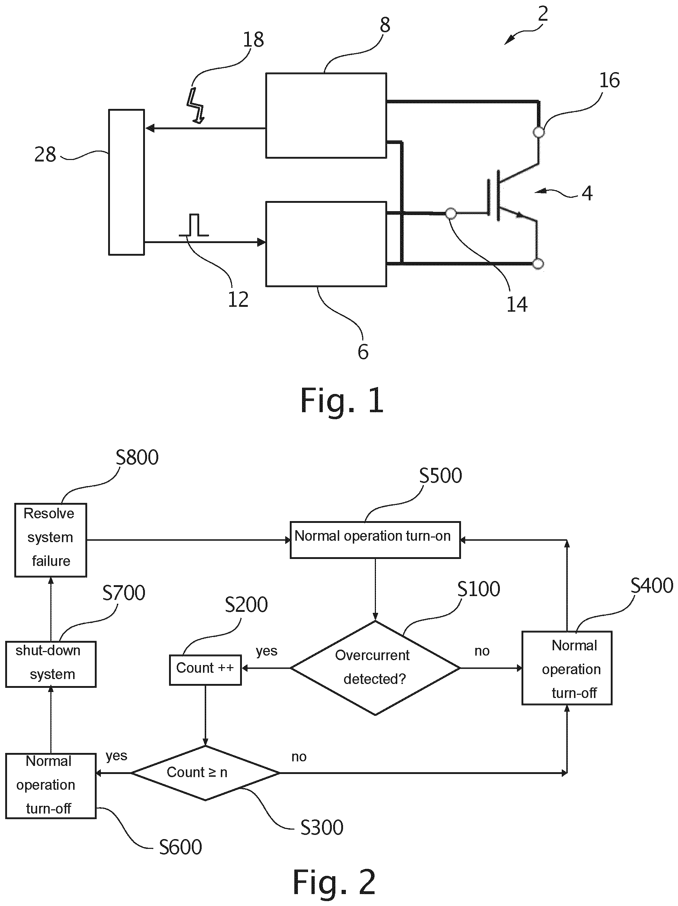

Figure 1 schematically shows a power electronic system 2 according to a preferred embodiment of the invention. In this embodiment the power electronic system 2 comprises a semiconductor device 4, a driver circuit 6, a detection means 8, and a controller 10. In this embodiment the semiconductor device 4 is an IGBT.

The driver circuit 6 is configured for receiving a logical signal 12, in this embodiment a PMW signal, from the controller 10 and is further configured for providing a gate signal to a gate 14 the semiconductor device 4 for switching the semiconductor device 4 in normal operation mode. In particular, the controller 10 provides the logical signals 12 that enables switching of the semiconductor device 4 in a switching cycle from an ON state into an OFF state and from the OFF state into the ON state.

The detection means 8 are configured for detecting a condition with current levels of a collector current at a collector 16 of the semiconductor device 16 above a predefined current-threshold limit. In this embodiment the predefined current-threshold limit is two times the nominal current level of the collector current in the ON state. Furthermore, the detection means 8 are configured for providing an alert signal 18 associated with the collector current levels of the semiconductor device 4 above the predefined current-threshold limit.

The controller 10 is configured for receiving the alert signal 18 from the detection means 8 and further configured for providing the logical signal 12 to the driver circuit 6. In this embodiment the detection means 8 is a desaturation detection.

The power electronic system 2 is configured to perform a method that comprises the steps
- Receiving the alert signal 18 by the controller 10, and
- Upon receipt of the alert signal 18, continuing switching the semiconductor device 4 in the normal operation mode for at least one switching cycle from the ON state into the OFF state and from the OFF state into the ON state.

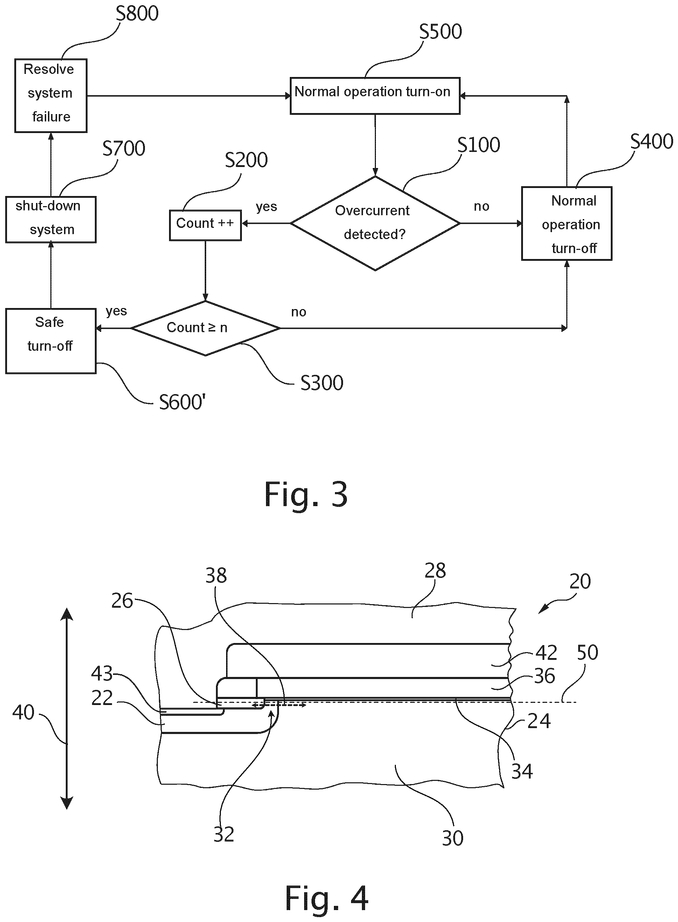

With reference to figures 2 and 3 which schematically show flow chart diagrams of two embodiments of the method for operating the power electronic system 2, the method is further described.

Figure 2 schematically shows a flow chart diagram of the method for operating a power electronic system 2 according to a preferred embodiment of the invention.

In this embodiment the method comprises the step S100 of monitoring operation to detect the condition with current levels of the collector current of the semiconductor device 4 above the predefined current-threshold limit. In case the condition with current levels of the collector current of the semiconductor device 4 above the predefined current-threshold limit is detected the alert signal 18 associated with the collector current levels of the semiconductor device 4 above the predefined current-threshold limit is provided by the detection means 8 and received by the controller 10. Furthermore, in this embodiment of the method, the method comprises the step S200 of increasing a counter upon receipt of the alert signal 18, and wherein the step of continuing switching the semiconductor device 4 in the normal operation mode for at least one switching cycle from the ON state into the OFF state and from the OFF state into the ON state is continued as long as the counter is below a predefined counter-threshold value. In other words, the method comprises the step 300 of determining if the counter is above or equal the predefined counter-threshold value. In case the counter is below the predefined counter-threshold value, a switching of the semiconductor device 4 from the ON state into the OFF state in normal operation mode is performed as indicated in S400 and a switching of the semiconductor device 4 from the OFF state into the ON state in normal operation mode is performed as indicated in S500.

Furthermore, in this embodiment of the method, the method comprises the step S700 of shutting the power electronic system 2 down after the counter has reached a predefined counter-threshold value. In order to do so, the method comprise the step S600 of switching the semiconductor device 4 into the OFF state in normal operation mode. The shut-down of the system 2 is followed by the step S800 of resolving a system failure that caused the condition with current levels of the collector current of the semiconductor device 4 above the predefined current-threshold limit. After this a switching of the semiconductor device 4 from the OFF state into the ON state in normal operation mode is performed as indicated in S500.

Figure 3 schematically shows a flow chart diagram of the method for operating a power electronic system 2 according to another preferred embodiment of the invention. The method shown in figure 3 is similar to the method as shown in figure 2, and only the differences are described in the following. In this embodiment of the method, when the counter has reached the predefined counter-threshold value (see step 300), and the shut-down of the system 2 is initiated, the semiconductor device 4 is not switched into the OFF state in normal operation mode, but as indicated in step S600', the semiconductor device 4 is switched into the OFF state in a safe-turnoff mode with a large gate resistor - Rg_{soft} -or by a step-wise reduction of the current driving the gate 14.

Figure 4 schematically shows a semiconductor device 20 with a planar gate architecture that can be used in the power electronic system of figure 1 or that can be operated according to the methods shown in figures 2 and 3.

The semiconductor device 20 comprises a base region 22 of a first conductivity type provided in a substrate 24. In this embodiment the base region 22 is of p-type. The semiconductor device 20 further comprises a source region 26 being of a second conductivity type - in this embodiment n-type - provided in the substrate 24 adjacent to the base region 22 for forming a first pn-junction. The source region 26 is configured to be connected to an emitter electrode 28. The semiconductor device 20 further comprises a drift region 30 being of the second conductivity type - in this embodiment n-type - provided in the substrate 24 adjacent to the base region 22 for forming a second pn-junction. The drift region 30 is arranged separate from the source region 26, such that a channel region 32 in between the source region 26 and the drift region 30 is formed in the base region 22. Furthermore, the drift region 30 is configured to be connected to a collector electrode (not shown on figure 4). Furthermore, the semiconductor device 20 comprises an insulation layer 34 arranged next to the channel region 32 for separating the channel region 32 from a gate electrode 36.

When a voltage V_{GE} is applied to the gate electrode 36 electric charges are induced, which generate the channel region 32, such that charge carriers can flow from the emitter electrode 28 to the collector electrode via the channel region 32. As in figure 3 the semiconductor device 20 is of planar gate architecture a charge carrier axis 38 along which the charges flow in the channel region 32 is arranged perpendicularly to a connection axis 40 that connects the emitter electrode 28 with the collector electrode.

As can further be seen in figure 4, in order to prevent that the gate electrode 36 is directly connected to the emitter electrode 28, a further insulation layer 42 is arranged on top of the gate electrode 36. Additionally, the semiconductor device 20 comprises a contact layer 43 adjacent to the base region 22, the source region 26, and the emitter electrode 28, the contact layer 43 being of the first conductivity type and having a higher carrier concentration than the base region 22.

Figure 5 schematically shows a profile of a doping concentration 44 of the semiconductor device 20 of figure 4 along a direction parallel to the charge carrier axis 38. The y-axis 46 of figure 4 shows the doping concentration in cm⁻³, while the x-axis 48 shows the location along the cutline 50 indicated in figure 4 parallel to the charge carrier axis 38.

As can be seen in figure 5, the doping concentration 44 for the semiconductor device 20 decreases from the source region 26 to the channel region 32. Furthermore, figure 4 shows that a ratio of a peak doping concentration 52 in cm⁻³ in the channel region 32 to a length 54 of the channel region 32 in cm between the first pn-junction and the second pn-junction along the charge carrier axis 38 is more than 5.8 · 10²¹ cm⁻⁴.

As can further be seen in figure 5, the semiconductor device 20 comprise an enhancement region 56 in the drift region 30, the enhancement region 56 being arrange along the charge carrier axis 38 adjacent to the channel region 56. For simplicity the enhancement region 56 is not shown in the schematic illustration of the semiconductor device 20 in figure 4. In this embodiment a ratio of the peak doping concentration 52 in the channel region 32 to a peak doping concentration 58 in the enhancement region 56 is more than 1.75 · 10².

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosed, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 2: power electronic system
- 4: semiconductor device, IGBT
- 6: driver circuit
- 8: detection means
- 10: controller
- 12: logical signal, PMW
- 14: gate
- 16: collector
- 18: alert signal
- 20: semiconductor device
- 22: base region
- 24: substrate
- 26: source region
- 28: emitter electrode
- 30: drift region
- 32: channel region
- 34: insulation layer
- 36: gate electrode
- 38: charge carrier axis
- 40: connection axis
- 42: further insulation layer
- 43: contact layer
- 44: doping concentration profile for device 20
- 46: y-axis, doping concentration
- 48: x-axis, location
- 50: cutline
- 52: peak doping concentration in channel region
- 54: length of channel region
- 56: enhancement region
- 58: peak doping concentration in enhancement region

- 110: left y-axis, collector current Ic in Ampere
- 112: right y-axis, collector-emitter voltage V_{CE} in Volts
- 114: time, in seconds
- 116: Curve of collector current during turn-off in normal operation mode
- 118: Curve of collector-emitter voltage during turn-off in normal operation mode
- 120: short circuit waveform of the collector current
- 122: short circuit waveform of the collector-emitter voltage
- 124: RBSOA current level, I_{RBSOA}
- 126: SCSOA current level
- 128: gap region
- 130: output characteristics for semiconductor device, where neither of features a), b), or c) of claim 2 are realized
- 132: output characteristics for semiconductor device, where features a), b), and/or c) of claim 2 are realized
- 134: y-axis, collector current Ic
- 136: x-axis, collector-emitter voltage V_{CE}
- 140: saturation current level Iₛₐₜ for device with output characteristics according to curve 130
- 142: saturation current level Iₛₐₜ for device with output characteristics according to curve 132
- 144: nominal current level Iₙₒₘ for device with output characteristics according to curve 132

## Claims

1. Method for operating a power electronic system (2), the system (2) comprising at least one semiconductor device (4, 20), a driver circuit (6), a detection means (8), and a controller (10),
the driver circuit (6) configured for receiving a logical signal (12) from the controller (10) and for providing a gate signal to the semiconductor device (4, 20) for switching the semiconductor device (4, 20) in a switching cycle from an ON state into an OFF state and from the OFF state into the ON state in normal operation mode,
the detection means (8) configured for detecting a condition with current levels of a collector current of the semiconductor device (4, 20) above a predefined current-threshold limit, and for providing an alert signal (18) associated with the collector current levels of the semiconductor device (4, 20) above the predefined current-threshold limit,
the controller (10) configured for receiving the alert signal (18) from the detection means (8) and configured for providing the logical signal (12) to the driver circuit (6),
the method comprising the steps:
- Receiving the alert signal (18) by the controller (10), and
- Upon receipt of the alert signal (18), continuing switching the semiconductor device (4, 20) in the normal operation mode for at least one switching cycle from the ON state into the OFF state and from the OFF state into the ON state.

2. Method according to the previous claim, wherein the semiconductor device (4, 20) is configured
a) to have a saturation current level Iₛₐₜ of the collector current greater or equal to 1.8 times the nominal current level of the collector current in the ON state, and/or
b) to have a doping concentration (44) of a channel region (32) and a length (54) of the channel region (32) between a first pn-junction and a second pn-junction along a charge carrier axis (38) such that a gate-emitter threshold voltage Vₜₕ at 25 °C is above 6 V, and such that at 25 °C for
i) a 6.5 kV semiconductor device (4, 20) a collector-emitter saturation voltage V_{CE(sat)} is in between 2.8 V and 3.2 V, and/or
ii) a 4.5 kV semiconductor device (4, 20) a collector-emitter saturation voltage V_{CE(sat)} is in between 2.1 V and 2.5 V, and/or
iii) a 3.3 kV semiconductor device (4, 20) a collector-emitter saturation voltage V_{CE(sat)} is in between 2.0 V and 2.5 V, and/or
iv) a 1.7 kV semiconductor device (4, 20) a collector-emitter saturation voltage V_{CE(sat)} is in between 1.6 V and 2.0 V, and/or
v) a 1.2 kV semiconductor device (4, 20) a collector-emitter saturation voltage V_{CE(sat)} is in between 1.3 V and 1.7 V; and/or
c) to have a ratio of a peak doping concentration (52) in cm⁻³ in the channel region (32) to a length (54) of the channel region (32) in cm between the first pn-junction and the second pn-junction along the charge carrier axis (38) of more than 5.8 · 10²¹ cm⁻⁴ for a planar gate architecture or of more than 5 · 10²⁰ cm⁻⁴ for a trench gate architecture.

3. Method according to any of the previous claim, wherein the method comprises the step of shutting the power electronic system (2) down after a predefined number of consecutive switching cycles from the ON state into the OFF state and from the OFF state into the ON state during which the alert signal (18) is received.

4. Method according to claim 3, wherein the step of shutting the power electronic system (2) down is performed by ceasing to provide the logical signal (12) to the driver circuit (6) by the controller (10) and/or by ceasing to provide the gate signal to the power semiconductor device (4, 20).

5. Method according to any of claims 3 or 4, wherein the step of shutting the power electronic system (2) down comprises the step of switching the semiconductor device (4, 20) into the OFF state in normal operation mode.

6. Method according to any of claims 3 or 4, wherein the step of shutting the power electronic system (2) down comprises the step of switching the semiconductor device (4, 20) into the OFF state in a safe-turnoff mode.

7. Method according to any of the previous claim, wherein the method comprises the step of monitoring operation to detect the condition with current levels of the collector current of the semiconductor device (4, 20) above the predefined current-threshold limit.

8. Method according to any of the previous claim, wherein the method comprises the step of increasing a counter upon receipt of the alert signal (18), and wherein the step of continuing switching the semiconductor device (4, 20) in the normal operation mode for at least one switching cycle from the ON state into the OFF state and from the OFF state into the ON state is continued as long as the counter is below a predefined counter-threshold value.

9. Method according to any of the previous claim, wherein the method comprises the step of increasing a counter upon receipt of the alert signal (18), and wherein the method comprises the step of shutting the power electronic system (2) down after the counter has reached a predefined counter-threshold value.

10. Power electronic system (2) comprising at least one semiconductor device (4, 20), a driver circuit (6), a detection means (8), and a controller (10),
the driver circuit (6) configured for receiving a logical signal (12) from the controller (10) and for providing a gate signal to the semiconductor device (4, 20) for switching the semiconductor device (4, 20) from the ON state into an OFF state and from the OFF state into the ON state in normal operation mode,
the detection means (8) configured for detecting a condition with current levels of the collector current of the semiconductor device (4, 20) above a predefined current-threshold limit, and for providing an alert signal (18) associated with the collector current levels of the semiconductor device (4, 20) above the predefined threshold limit,
the controller (10) configured for receiving the alert signal (18) from the detection means (8) and configured for providing the logical signal (12) to the driver circuit (6),
and wherein the system (2) is configured for performing the method according to any of the previous method claims.

11. Power electronic system (2) according to the previous claim wherein the detection means (8) is a desaturation detection circuit or a shunt resistor circuit.

12. Power electronic system (2) according to any of the previous system claims, wherein the detection means (8) is a desaturation detection circuit free of a capacitor and/or wherein the desaturation detection circuit is integrated into the driver circuit (6).

13. Power electronic system (2) according to any of the previous system claims, wherein the driver circuit (6) is free of a gate resistor for performing a safe-turnoff, and wherein the power electronic system (2) is configured for performing the method according to any of the previous method claims 1 to 5 or 7 to 9.

14. Power electronic system (2) according to any of the previous system claims comprising at least one second semiconductor device, wherein the first semiconductor device (4, 20) is configured such that the saturation current level Iₛₐₜ of the collector current of the first semiconductor device (4, 20) lies below an I_{RBSOA} collector current defined by a reverse-bias safe operating area of the second semiconductor device.
